# EUROPÄISCHE PATENTSCHRIFT

(11) **EP 2 807 057 B1**
(45) Veröffentlichungstag und Bekanntmachung des Hinweises auf die Patenterteilung: **22.03.2017**
(21) Anmeldenummer: 13700862.9
(22) Anmeldetag: 14.01.2013
(51) Int. Cl.: B60R 21/017

(54) **VERFAHREN UND VORRICHTUNG ZUM ERKENNEN EINER EINSATZFÄHIGKEIT EINER ANSTEUERVORRICHTUNG**
METHOD AND DEVICE FOR DETECTING A USABILITY OF A CONTROL DEVICE
PROCÉDÉ ET DISPOSITIF POUR DÉTECTER UNE DISPONIBILITÉ OPÉRATIONNELLE D'UN DISPOSITIF DE COMMANDE

(30) Priorität: 25.01.2012 DE 102012201049
(43) Veröffentlichungstag der Anmeldung: 03.12.2014
(73) Patentinhaber: Robert Bosch GmbH, 70442 Stuttgart (DE)
(72) Erfinder: ZUSCHLAG, Rainer, 71636 Ludwigsburg (DE); SCHUMACHER, Hartmut, 71691 Freiberg (DE)
(86) Internationale Anmeldenummer: PCT/EP2013/050565
(87) Internationale Veröffentlichungsnummer: WO 2013/110523

(56) Entgegenhaltungen:
- DE-A1- 4 432 301
- DE-A1-102005 054 738

## Beschreibung

Die vorliegende Erfindung bezieht sich auf ein Verfahren und eine Vorrichtung zum Erkennen einer Einsatzfähigkeit einer Ansteuervorrichtung einer Sicherheitseinrichtung in einem Fahrzeug.

### Stand der Technik

Derzeit wird bei der Erkennung der Einsatzfähigkeit einer Ansteuervorrichtung für eine Sicherheitseinrichtung in einem Fahrzeug, beispielsweise einer Zündpille bei einem pyrotechnischen Aktuator, lediglich das Vorhandensein des Aktuators mittels einer Zündkreismessung festgestellt.

Bei einer Zündkreismessung wird der Widerstandswert des Aktuators gemessen, sowie festgestellt, ob ein Kurzschluss gegen eine externe Spannung vorliegt.

Mit dem derzeit verwendeten Messverfahren kann nicht festgestellt werden, ob ein Aktuator, der eine Vorzugsstromrichtung hat, auch richtig herum eingebaut wurde.

Aus der DE 10 2005 054 738 A1 ist eine Sicherheitsvorrichtung für ein Fahrzeug mit mindestens einem Rückhaltemittel zum Schutz von Insassen des Fahrzeugs während eines kritischen Betriebszustands des Fahrzeugs bekannt, bei dem eine Schalteinrichtung die Funktionsfähigkeiten mindestens einer Auslöseeinheit des mindestens einem Rückhaltemittel durch ein Anregen der Auslöseeinheit des mindestens einen Rückhaltemittels mit einem Stromimpuls in Abhängigkeit von einem Überwachungssignal überwacht, wobei das Anregen der mindestens einer Auslöseeinheit des mindestens einen Rückhaltemittels mit dem Strompuls beendet wird, bevor das Rückhaltemittel ausgewählt wird. Ein Abklingverhalten einer an der mindestens einer Auslöseeinheit des mindestens einen Rückhaltemittels anliegenden Messspannung wird als eine Funktion einer Messzeit nach einem Beenden des Anregens erfasst.

Aus der DE 44 32 301 A1 ist ein elektronisches Steuergerät für Rückhaltesysteme von Fahrzeuginsassen bekannt, dass eine von einer Steuerstufe gesteuerten Endstufe umfasst, wobei jede der Anschlussleitungen der Endstufe über ein von einem Mikrorechner steuerbares Schaltelement mit dem Masseanschluss verbindbar ist. Durch Auswertung der auf der Leitung anstehenden Spannung sind alle wesentlichen Bauelemente, insbesondere der Endstufe, überprüfbar.

### Kern und Vorteile der Erfindung

Der Kern der vorliegenden Erfindung ist es, ein Verfahren bzw. eine Vorrichtung mit dem bzw. mit der eine Einsatzfähigkeit einer Ansteuervorrichtung einer Sicherheitseinrichtung erkannt werden kann. Das Verfahren bzw. die Vorrichtung verwendet dafür eine limitierte Menge an Energie, so dass eine ungewollte Auslösung der Sicherheitseinrichtung ausgeschlossen ist.

Erfindungsgemäß wird dieses durch die Merkmale der unabhängigen Ansprüche gelöst. Vorteilhafte Weiterbildungen und Ausgestaltungen ergeben sich aus den Unteransprüchen.

Die vorliegende Erfindung schafft ein Verfahren zum Erkennen einer Einsatzfähigkeit einer Ansteuervorrichtung einer Sicherheitseinrichtung in einem Fahrzeug mit den Schritten:
- Anlegen einer Spannung an die Ansteuervorrichtung
- Erfassen eines Spannungsverlaufs und/oder Stromverlaufs an der Ansteuervorrichtung
- Erkennen einer Einsatzfähigkeit der Ansteuervorrichtung abhängig von dem erfassten Spannungsverlauf und/oder Stromverlaufs.

Die Erfindung schafft weiterhin eine Vorrichtung zum Erkennen einer Einsatzfähigkeit einer Ansteuervorrichtung einer Sicherheitseinrichtung in einem Fahrzeug, wobei die Vorrichtung
- Mittel zum Anlegen einer Spannung an die Ansteuervorrichtung;
- Mittel zum Erfassen eines Spannungsverlaufs an der Ansteuervorrichtung;
- Mittel zum Erkennen einer Einsatzfähigkeit der Ansteuervorrichtung abhängig von dem erfassten Spannungsverlauf
aufweist.

Unter einer Sicherheitseinrichtung in einem Fahrzeug kann vorliegenden verstanden werden, jegliche Einrichtung in einem Fahrzeug, die die Insassen, das Fahrzeug oder weitere Verkehrsteilnehmer vor Schaden bewahren. Darunter fallen beispielsweise Überrollbügel, aktive Motorhauben, aktive Fahrzeugsitze. Aktive Motorhauben sind Motorhauben, die durch einen geeigneten Aktuator bewegt werden, damit ein weitere Verkehrsteilnehmer (Fußgänger, Fahrradfahrer, Motorradfahrer) vor schweren Verletzten bewahrt wird, wenn er bei einer Kollision auf der Motorhaube aufschlägt. Aktive Fahrzeugsitze sind Fahrzeugsitze, die im Falle einer Kollision oder bereits im Vorfeld zu einer Kollisionen, den Insassen in einer optimale Position bewegen, damit weitere Sicherheitseinrichtungen maximale Schutzwirkungen entfalten können.

Unter einer Ansteuereinrichtung für eine solche Sicherheitseinrichtung in einem Fahrzeug kann vorliegenden verstanden werden, jegliche Einrichtung, die dazu geeignet ist eine Sicherheitsanrichtung zu aktivieren, auszulösen, zu bewegen oder einzustellen. Beispielsweise kann es sich bei einer Ansteuereinrichtung um einen magnetischen Aktuator zur Ansteuerung von Sicherheitseinrichtungen in einem Fahrzeug handeln. Ein magnetischer Aktuator kann dabei als Spule (Induktivität), ausgeführt sein, die bei Ansteuerung bzw. Aktivierung durch einen Strompuls ein Magnetfeld erzeugt. Ein solches Magnetfeld übt dann eine Kraft auf ein magnetisierbares Material aus, das sich hierauf in dem Magnetfeld bewegt. Die Bewegung wiederum kann zum Entsichern einer Haltevorrichtung führen, wodurch eine Sicherheitseinrichtung ausgelöst werden kann. Beispielsweise dadurch, dass die Sicherheitseinrichtung selbst unter mechanischer Spannung steht und die Energie, die in der Spannung gespeichert ist, durch das Entsichern der Haltevorrichtung freigesetzt wird. Meist weist ein solcher magnetischer Aktuator parallel zu der Spule eine Freilaufdiode auf.

Unter einer Freilaufdiode kann vorliegend eine Diode verstanden werden, die so angebracht ist, dass im Falle einer fehlerhaften Polung ein Strom anstelle durch den Aktuator zu fließen, durch die Freilaufdiode fließt und so den Aktuator vor möglicher Zerstörung oder Fehlauslösung bewahrt.

Unter einer Einsatzfähigkeit einer solchen Ansteuereinrichtung kann vorliegenden verstanden werden festzustellen, dass die Ansteuervorrichtung, wenn sie eine Vorzugsstromrichtung aufweist, richtig herum bspw. richtig gepolt eingebaut wurde. Ein verpolt eingebauter Aktuator ist nicht in der Lage eine Sicherheitseinrichtung zu aktiveren bzw. auszulösen.

Unter einer Vorrichtung zum Erkennen einer solchen Einsatzfähigkeit kann vorliegenden verstanden werden, ein Bauteil, vorzugsweise ein elektrisches Bauteil, das entweder separat im Fahrzeug untergebracht ist und entsprechend mit dem deren Einsatzfähigkeit zu erkennenden Ansteuereinrichtung verbunden ist oder Teil einer Ansteuereinrichtung zur Ansteuerung von Sicherheitsrichtungen sein, beispielsweise Teil eines Airbagsteuergeräts oder einer sogenannten Safety-Unit. Eine Safety-Unit ist ein Steuergerät, das unter anderem dazu konfiguriert ist verschiedenste Sicherheitseinrichtungen in einem Fahrzeug anzusteuern bzw. zu aktiveren.

In einer vorteilhaften Ausgestaltung umfasst das erfindungsgemäße Verfahren, dass im Schritt des Anlegens eine Spannung aus einer separaten Energiequelle angelegt wird und einen den weiteren Schritt:
- Laden der separaten Energiereserve.

Unter einer separaten Energiereserve kann vorliegenden verstanden werden, jegliches Bauteil, das dazu in der Lage ist elektrische Energie zu speichern. Vorzugsweise wird darunter vorliegend ein Kondensator, eine Batterie oder ein Akku, verstanden.

Weiterhin von Vorteil ist, wenn das Fahrzeug eine weitere Energiequelle aufweist, dass die separate Energiequelle durch einen ersten Schalter (SVS) mit der Energiequelle des Fahrzeugs verbindbar ist und dass im Schritt des Ladens die separate Energiequelle durch Verbinden mit der Energiequelle des Fahrzeugs mittels des ersten Schalters (SVS), insbesondere durch Schließen des ersten Schalters (SVS), geladen wird.

Weiterhin von Vorteil ist, dass im Schritt des Ladens nach dem Aufladen der separaten Energiequelle die Verbindung zur Energiequelle des Fahrzeugs mittels des ersten Schalters (SVS), insbesondere durch Öffnen des ersten Schalters (SVS), getrennt wird.

Unter einer weiteren Energiequelle des Fahrzeugs kann vorliegenden verstanden werden, jegliches Bauteil, das dazu in Lage ist elektrische Energie zu speichern. Vorzugsweise wird darunter vorliegend eine Fahrzeugbatterie verstanden.

Unter verbindbar sein kann vorliegende verstanden werden, dass zwischen den beiden Bauteilen eine elektrische Verbindung vorherrscht, die mittels eines geeigneten Bauteils vollständig hergestellt werden kann. Ein solches Bauteil kann zum Beispiel ein entsprechend ausgestalteter Schalter sein oder aber auch Teil einer integrierten Schaltung sein, an die die beiden Bauteile angeschlossen sind.

Unter einem ersten Schalter (SVS) kann vorliegend jegliches Bauteil verstanden werden, das zum Schalten geeignet ist. Vorzugsweise wird vorliegend darunter ein elektrischer Schalter verstanden oder ein Teil einer integrierten Schaltung. Dieser erste Schalter kann durch einen sogenannten Sicherheitsschalter einer Ansteuereinrichtung realisiert werden. Der Sicherheitsschalter befindet sich in der elektrischen Schaltung auf einem seriellen Pfad von der Energiequelle zur Ansteuervorrichtung bzw. zum Aktuator. Ein Sicherheitsschalter zeichnet sich dadurch aus, dass eine Auslösung bzw. Aktivierung der Ansteuervorrichtung bzw. des Aktuators nur möglich ist, wenn der Sicherheitsschalter geschlossen ist.

In einer vorteilhaften Ausgestaltung umfasst das erfindungsgemäße Verfahren, wenn die Ansteuervorrichtung eine Grenzwert (t_{MaxNoFire}) für eine Zeit aufweist bzw. einen Grenzwert (I_{MaxNoFire}) für einen Strom aufweist und die Ansteuervorrichtung nicht auslöst, wenn eine Spannung an die Ansteuervorrichtung für maximal eine Zeit angelegt wird, die dem Grenzwert (t_{MaxNoFire}) für eine Zeit entspricht und die Ansteuervorrichtung nicht auslöst, wenn durch die Ansteuervorrichtung ein Strom fließt, der maximal dem Grenzwert (I_{MaxNoFire}) für einen Strom entspricht, einen weiteren Schritt:
- Trennen der angelegten Spannung, nach maximal der Zeit, die dem Grenzwert (t_{MaxNoFire}) für ein Zeit entspricht oder bevor ein Strom fließt, der dem Grenzwert (I_{MaxNoFire})für einen Strom entspricht.

Unter einem Grenzwert (t_{MaxNoFire}) für die Zeit kann vorliegend verstanden werden, eine maximale Zeitdauer, innerhalb der ein Aktuator bzw. eine Ansteuervorrichtung dieser Erfindung die Sicherheitseinrichtung nicht aktivieren bzw. auslösen wird. Eine solche Zeitdauer kann durch den Aufbau der Ansteuervorrichtung bedingt sein oder durch den Aufbau der Ansteuervorrichtung vorgesehen sein.

Unter einem Grenzwert (I_{MaxNoFire}) für einen Strom kann vorliegend verstanden werden, ein Strom bzw. eine Stromstärke, die dauerhaft durch einen Aktuator bzw. eine Ansteuervorrichtung dieser Erfindung fließen kann, ohne dass dies eine Aktivierung bzw. Auslösung der Sicherheitseinrichtung zur Folge hat. Ein solche Strom bzw. eine solche Stromstärke kann durch den Aufbau der Ansteuervorrichtung bedingt sein oder durch den Aufbau der Ansteuervorrichtung vorgesehen sein. Beispielsweise durch die Eigenschaften einer Spule, im Falle eines magnetischen Aktuators.

Zur Auslösung bzw. Aktivierung einer Ansteuervorrichtung bzw. eines Aktuators dieser Erfindung muss für eine minimale Zeitdauer ein minimaler Strom durch eine Spule der Ansteuervorrichtung bzw. des Aktuators fließen. Diese minimale Zeitdauer ist länger als der Grenzwert (t_{MaxNoFire}) für Zeit und der minimale Strom ist größer als der Grenzwert (I_{MaxNoFire}) für einen Strom.

In einer vorteilhaften Ausgestaltung umfasst das erfindungsgemäße Verfahren, dass die Einsatzfähigkeit dann erkannt wird, wenn der erfasste Spannungsverlauf einen charakteristischen Spannungsanstieg aufweist.

In einer vorteilhaften Ausgestaltung umfasst das erfindungsgemäße Verfahren, dass die Ersatzfähigkeit als nicht gegeben erkannt wird, wenn der erfasste Spannungsverlauf keinen charakteristischen Spannungsanstieg aufweist.

Unter einem charakteristischen Spannungsanstieg kann vorliegend verstanden werden, dass beim Anlegen einer Spannung im ersten Augenblick kein Strom durch eine Spule der Ansteuervorrichtung bzw. des Aktuators dieser Erfindung fließt. Es kommt zu einem schlagartigen Spannungsanstieg durch das Anlegen einer Spannung. Dieser Spannungsanstieg ist charakteristisch und kann gemessen bzw. zurückgemessen werden und die angelegte Spannung kann wieder getrennt bzw. abgeschaltet werden, bevor ein Strom zu fließen begonnen hat, der größer ist als der Grenzwert für einen Strom. In jedem Fall wird die angelegte Spannung getrennt bzw. abschaltet bevor die Spannung für einen Grenzwert für die Zeit angelegt war.

In Fällen in denen eine Ansteuervorrichtung bzw. ein Aktuator dieser Erfindung nicht Einsatzfähig ist, z.B. weil er fehlerhaft gepolt angeschlossen wurde, bleibt der erwartete schlagartige Spannungsanstieg aus. Gemessen bzw. zurückgemessen wird dann lediglich eine Spannung bzw. eine Durchlassspannung, die an anderen Bauteilen, bspw. an einer Freilaufdiode abfällt.

In einer alternativen Realisierung des erfindungsgemäßen Verfahrens bzw. der erfindungsgemäßen Vorrichtung zeichnet sich der charakteristische Spannungsanstieg bzw. Stromanstieg dadurch aus, dass bei Einsatzfähigkeit ein erster Spannungsverlauf mit einem ersten Spannungsanstieg und ein zweiter Spannungsverlauf mit einem zweiten Spannungsanstieg erfasst werden und dass der erste Spannungsanstieg schneller bzw. deutlich schneller erfolgt als der zweite Spannungsanstieg.

Liegt keine Einsatzfähigkeit vor, so wird ein erster Spannungsverlauf mit einem ersten Spannungsanstieg und ein zweiter Spannungsverlauf mit einem zweiten Spannungsanstieg erfasst und der erste und der zweite Spannungsverlauf erfolgen gleichschnell bzw. quasi gleichschnell.

Weiterhin ist es von Vorteil, dass im Schritt des Erkennens der erfasste Spannungsverlauf mit einem Grenzwert (u_{Grenz}) für eine Spannung verglichen wird. Wenn im Schritt des Erkennens der erfasste Spannungsverlauf von dem Grenzwert (u_{Grenz}) für ein Spannung abweicht, so erkennt das erfindungsgemäße Verfahren, dass die Ansteuervorrichtung bzw. der Aktuator nicht einsatzfähig ist. Die Abweichung kann darin bestehen, dass ein Grenzwert nicht erreicht wird oder dass ein Grenzwert nicht erreicht werden darf. Es kann daraufhin ein entsprechendes Signal ausgegeben werden, dass beispielsweise dazu genutzt werden kann, um dem Fahrer des Fahrzeugs einen geeigneten Warnhinweis zu geben, bspw. durch Ansteuern einer Warnlampe. Oder das Signal kann genutzt werden, um eine Fehlermeldung in einem geeigneten Speicher abzulegen.

In einer vorteilhaften Ausgestaltung umfasst das erfindungsgemäße Verfahren, dass eine Einsatzfähigkeit der Ansteuervorrichtung der Sicherheitseinrichtung eine korrekte Polung der Ansteuervorrichtung ist.

Unter einer Polung kann vorliegend verstanden werden, bei der Ansteuervorrichtung bzw. dem Aktuator dieser Erfindung handelt es sich um elektrisches Bauteil, dass zumindest einen Anschluss für eine positive Spannung und einen Anschluss für eine negative Spannung. Eine Verbindung dieser Anschlüsse mit einer Spannungs- bzw. Energiequelle für elektrische Energie nennt man Polung. Ein korrekte Polung liegt dann vor, wenn der Anschluss für eine negative Spannung mit einem Anschluss für negative Spannung der Spannungs- bzw. Energiequelle verbunden wird und entsprechend der Anschluss für eine positive Spannung mit einem Anschluss für positive Spannung. Ein fehlerhafte Polung bzw. Verpolung liegt vor, wenn der Anschluss für negative Spannung mit dem Anschluss für positive Spannung der Spannungs- bzw. Energiequelle verbunden wurde und entsprechend der Anschluss für positive Spannung mit dem Anschluss für negative Spannung.

In einer vorteilhaften Ausgestaltung umfasst das erfindungsgemäße Verfahren, dass an die Ansteuervorrichtung mittels mindestens eines zweiten Schalters (HS) die Spannung anlegbar ist und wobei im Schritt des Anlegens mittels des mindestens einen zweiten Schalters (HS) eine Spannung angelegt wird, insbesondere der mindestens eine zweite Schalter geschlossen wird.

Unter einem zweiten Schalter (HS) kann vorliegend verstanden werden, jegliches Bauteil verstanden werden, das zum Schalten geeignet ist. Vorzugsweise wird vorliegend darunter ein elektrisches Schalter verstanden oder ein Teil einer integrierten Schaltung. Dieser zweite Schalter kann durch einen sogenannten High-Side Schalter einer Ansteuereinrichtung realisiert werden. Der High-Side Schalter befindet sich in der elektrischen Schaltung in Stromrichtung vor dem anzusteuernden bzw. zu aktivierenden Bauteil.

Der zweite Schalter (HS) oder High-Side Schalter eignet sich in vorteilhafter Weise dazu, an ihm den Spannungsverlauf zu erfassen. Da der zweite Schalter (HS) oder High-Side Schalter meist in Ansteuervorrichtungen vorhanden ist und meist bereits wegen anderen Funktionen eine Spannungserfassung an dem High-Side Schalter vorgesehen ist, entsteht durch weitere Nutzung der erfassten Spannung durch das erfindungsgemäße Verfahren bzw. die erfindungsgemäße Vorrichtung kein Zusatzaufwand bei der Realisierung des erfindungsgemäßen Verfahrens bzw. der erfindungsgemäßen Vorrichtung.

In einer vorteilhaften Ausgestaltung umfasst das erfindungsgemäße Verfahren, dass die Ansteuervorrichtung mittels des mindestens eine zweite Schalters (HS) und eines mindestens dritten Schalters (LS) auslösbar ist und dass im Schritt des Anlegens mittels des mindestens einen dritten Schalters (LS) eine Auslösung unterbunden wird, insbesondere der mindestens eine dritte Schalter nicht geschlossen wird.

Unter einem dritten Schalter (LS) kann vorliegend verstanden werden, jegliches Bauteil verstanden werden, das zum Schalten geeignet ist. Vorzugsweise wird vorliegend darunter ein elektrisches Schalter verstanden oder ein Teil einer integrierten Schaltung. Dieser dritte Schalter kann durch einen sogenannten Low-Side Schalter einer Ansteuereinrichtung realisiert werden. Der Low-Side Schalter befindet sich in der elektrischen Schaltung in Stromrichtung hinter dem anzusteuernden bzw. zu aktivierenden Bauteil.

Der dritte Schalter (LS) oder Low-Side Schalter eignet sich für eine alternative Realisierung des erfindungsgemäßen Verfahrens ebenfalls in vorteilhafter Weise dazu, an ihm den Spannungsverlauf zu erfassen. Da der dritte Schalter (LS) oder Low-Side Schalter meist in Ansteuervorrichtungen vorhanden ist und meist bereits wegen anderen Funktionen eine Spannungserfassung an dem Low-Side Schalter vorgesehen ist, entsteht durch weitere Nutzung der erfassten Spannung durch eine alternative Realisierung des erfindungsgemäßen Verfahren bzw. der erfindungsgemäßen Vorrichtung kein Zusatzaufwand.

In einer vorteilhaften Ausgestaltung weist die erfindungsgemäße Vorrichtung eine separate Energiequelle zum Bereitstellen einer Spannung zum Anlegen an die Ansteuervorrichtung auf.

Weiterhin ist von Vorteil, wenn das Fahrzeug eine weitere Energiequelle aufweist, dass die erfindungsgemäße Vorrichtung einen erster Schalter aufweist, wobei die separate Energiequelle durch einen ersten Schalters (SVS) mit der Energiequelle des Fahrzeugs verbindbar ist und die Vorrichtung die separate Energiequelle durch Verbinden mit der Energiequelle des Fahrzeugs mittels des ersten Schalters (SVS), insbesondere durch Schließen des ersten Schalters (SVS), lädt.

Weiterhin ist von Vorteil, dass die erfindungsgemäße Vorrichtung die Energiequelle des Fahrzeugs mittels des ersten Schalters (SVS), insbesondere durch Öffnen des Schalters, trennt.

In einer vorteilhaften Ausgestaltung umfasst die erfindungsgemäße Vorrichtung, wenn die Ansteuervorrichtung eine Grenzwert (t_{MaxNoFire}) für eine Zeit aufweist bzw. einen Grenzwert (I_{MaxNoFire}) für einen Strom aufweist und die Ansteuervorrichtung nicht auslöst, wenn eine Spannung an die Ansteuervorrichtung für maximal eine Zeit angelegt wird, die dem Grenzwert (t_{MaxNoFire}) für eine Zeit entspricht und die Ansteuervorrichtung nicht auslöst, wenn durch die Ansteuervorrichtung ein Strom fließt, der maximal dem Grenzwert (I_{MaxNoFire}) für einen Strom entspricht, dass die separate Energiereserve eine Kapazität aufweist, wobei die Kapazität maximal soviel Energie speichern kann, dass die Spannung für maximal eine Zeit an die Ansteuervorrichtung angelegt werden kann, die dem Grenzwert (t_{MaxNoFire}) für eine Zeit entspricht bzw. die Spannung maximal solange angelegt werden kann, bis ein Strom fließt, der dem Grenzwert (I_{MaxNoFire}) für einen Strom entspricht.

In einer vorteilhaften Ausgestaltung umfasst die erfindungsgemäße Vorrichtung, dass die Ansteuervorrichtung mindestens einen zweiten Schalter (HS) und mindestens einen dritten Schalter (LS) aufweist und zum Ansteuern der Sicherheitseinrichtung der mindestens eine zweite Schalter (HS) und der mindestens eine dritte Schalter (LS) geschlossen werden, und die Mittel zum Anlegen einer Spannung zum Anlegen der Spannung den mindestens einen zweiten Schalter (HS) schließen und den mindestens einen dritten Schalter (LS) nicht schließen.

In einer vorteilhaften Ausgestaltung umfasst die Erfindungsgemäße Vorrichtung, dass die separate Energiereserve zwischen dem ersten Schalter (SVS) und dem mindestens einen zweiten Schalter (HS) angeordnet ist.

Die erfindungsgemäße Vorrichtung wird in vorteilhafter Weise für Ansteuervorrichtungen eingesetzt, die mindestens ein elektrisches Bauteil aufweisen, wobei ein solches Bauteil einen induktiven Charakter aufweist.

Unter einem Bauteil, das einen induktiven Charakter aufweist kann vorliegend verstanden werden, jegliches Element, das dazu geeignet ist ein Magnetfeld zu erzeugen. Zum Beispiel eine elektrische Spule.

Das erfindungsgemäße Verfahren kann vollständig durch ein geeignetes Programm, das auf einem Datenträger gespeichert ist und mittels einer entsprechend konfigurierten Recheneinheit, beispielsweise mittels eines Mikrocontrollers (µC), ausgeführt wird, realisiert werden. Genauso ist es denkbar, dass erfindungsgemäße Verfahren vollständig oder zusätzlich teilweise durch geeignete Schaltungen, die in Hardware realisiert sind, umzusetzen.

Dabei ist denkbar, dass der erste Schalter (SVS) oder Sicherheitsschalter durch ein geeignetes Programm, das auf einem Datenträger gespeichert ist und mittels einer entsprechend konfigurierten Recheneinheit, beispielsweise mittels eines Mikrocontrollers (µC), ausgeführt wird, gesteuert wird und der zweite Schalter (HS) oder High-Side Schalter und der dritte Schalter (LS) oder Low-Side Schalter durch einen separaten Hardware-Pfad kontrolliert bzw. gesteuert werden.

### Zeichnungen

Nachfolgend werden Ausführungsbeispiele der Erfindung anhand von Zeichnungen erläutert. Es zeigen
Fig. 1 ein Diagramm eines Spannungs-/ Stromverlaufs
Fig. 2 ein weiteres Diagramm eines Spannungs-/ Stromverlaufs
Fig. 3 ein Blockschaltbild
Fig. 4 ein Diagramm mit Grenzwerten für einen Strom
Fig. 5a ein weiteres Diagramm eines Spannungs-/ Stromverlaufs
Fig. 5b einen vergrößerten Bereich eines Diagramms eines Spannungs-/ Stromverlaufs
Fig. 6a ein weiteres Diagramm eines Spannungs-/ Stromverlaufs
Fig. 6b einen vergrößerten Bereich eines Diagramms eines Spannungs-/ Stromverlaufs
Fig. 7 ein weiteres Blockschaltbild
Fig. 8 ein Ablaufdiagramm des Verfahrens

### Beschreibung von Ausführungsbeispielen

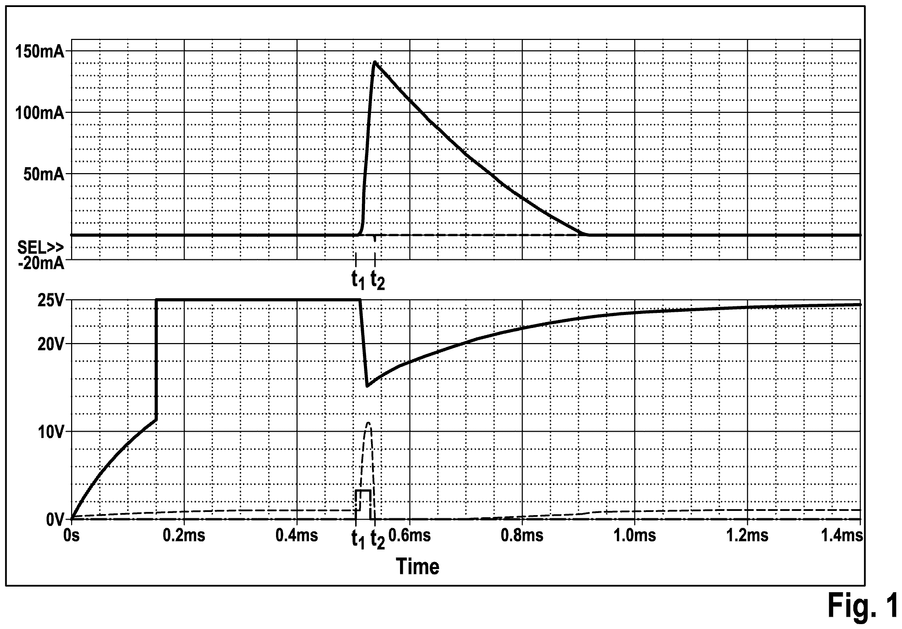

Fig.1 zeigt ein Diagramm eines erfassten Spannungs- und Stromverlaufs bei Ablauf des erfindungsgemäßen Verfahrens mittels der erfindungsgemäßen Vorrichtung, wenn die Ansteuervorrichtung bzw. der Aktuator dieser Erfindung korrekt gepolt wurde.

Im oberen Diagramm sind die Stromverläufe über die Zeit durch die Ansteuervorrichtung bzw. den Aktuator und durch die Freilaufdiode aufgetragen. Die durchgezogene Linie gibt dabei den Stromverlauf durch die Ansteuervorrichtung bzw. den Aktuator wieder. Die gestrichelte Linie gibt dabei den Stromverlauf durch die Freilaufdiode wieder.

Im unteren Diagramm sind die Spannungsverläufe über die Zeit aufgetragen, die an der separaten Engeriequelle, beispielsweise einem EMV-Kodensator, dem zweiten Schalter (HS) oder dem High-Side Schalter abfallen, sowie der Spannungsverlauf zur Ansteuerung des zweiten Schalters (HS) bzw. des High-Side Schalters und des dritten Schalters (LS) bzw. des Low-Side-Schalters. Die durchgezogene Linie gibt dabei den Spannungsverlauf an der separaten Energiequelle, beispielsweise einem EMV-Kondensator wieder, die gestrichelte Linie gibt dabei den Spannungsverlauf an dem zweiten Schalter (HS) bzw. dem High-Side Schalter wieder und die ge-punkt-strich-elte Linie gibt dabei den Spannungsverlauf zur Ansteuerung des zweiten Schalters (HS) bzw. High-Side Schalters und des dritten Schalters (LS) bzw. Low-Side Schalters durch eine Verarbeitungseinrichtung (µC) wieder.

Es ist deutlich zu erkennen, dass zum Zeitpunkt t1 des Anlegens einer Spannung ein Spannungsanstieg im Spannungsverlauf an dem zweiten Schalter (HS) bzw. High-Side Schalter (unteres Diagramm, gestrichelte Linie) stattfindet. Gleichzeit ist zu erkennen, dass ein Strom beginnt durch den Aktuator zu fließen (oberes Diagramm, durchgezogene Linie). Der Strom durch die Freilaufdiode zeigt keinen nennenswerten Wert (oberes Diagramm, gestrichelte Linie). Daraus kann die Einsatzfähigkeit der Ansteuervorrichtung bzw. des Aktuators erkannt werden.

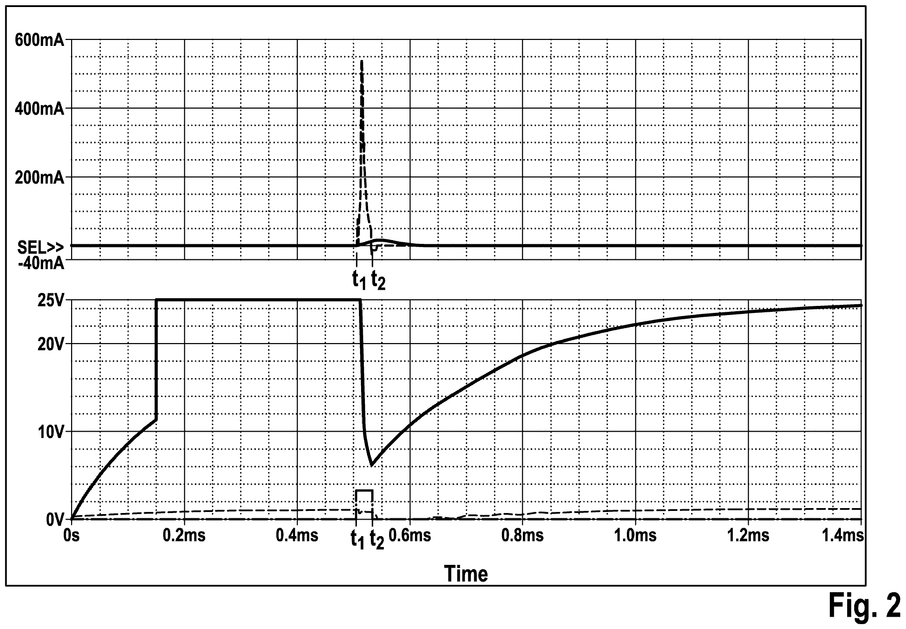

Fig.2 zeigt ein Diagramm eines erfassten Spannungs- und Stromverlaufs bei Ablauf des erfindungsgemäßen Verfahrens mittels der erfindungsgemäßen Vorrichtung, wenn die Ansteuervorrichtung bzw. der Aktuator dieser Erfindung fehlerhaft gepolt bzw. verpolt wurde.

Im oberen Diagramm sind die Stromverläufe über die Zeit durch die Ansteuervorrichtung bzw. den Aktuator und durch die Freilaufdiode aufgetragen. Die durchgezogene Linie gibt dabei den Stromverlauf durch die Ansteuervorrichtung bzw. den Aktuator wieder. Die gestrichelte Linie gibt dabei den Stromverlauf durch die Freilaufdiode wieder.

Im unteren Diagramm sind die Spannungsverläufe über die Zeit aufgetragen, die an der separaten Engeriequelle, beispielsweise einem EMV-Kodensator, dem zweiten Schalter (HS) oder dem High-Side Schalter abfallen, sowie der Spannungsverlauf zur Ansteuerung des zweiten Schalters (HS) bzw. des High-Side Schalters und des dritten Schalters (LS) bzw. des Low-Side-Schalters. Die durchgezogene Linie gibt dabei den Spannungsverlauf an der separaten Energiequelle, beispielsweise einem EMV-Kondensator wieder, die gestrichelte Linie gibt dabei den Spannungsverlauf an dem zweiten Schalter (HS) bzw. dem High-Side Schalter wieder und die ge-punkt-strich-elte Linie gibt dabei den Spannungsverlauf zur Ansteuerung des zweiten Schalters (HS) bzw. High-Side Schalters und des dritten Schalters (LS) bzw. Low-Side Schalters durch eine Verarbeitungseinrichtung (µC) wieder.

Es ist deutlich zu erkennen, dass zum Zeitpunkt t1 des Anlegens einer Spannung kein Spannungsanstieg im Spannungsverlauf an dem zweiten Schalter (HS) bzw. dem High-Side Schalter (unteres Diagramm, gestrichelte Linie) stattfindet. Gleichzeit ist zu erkennen, dass ein Strom beginnt durch die Freilaufdiode zu fließen (oberes Diagramm, gestrichelte Linie). Der Strom durch die Ansteuervorrichtung bzw. den Aktuator zeigt keinen nennenswerten Wert (oberes Diagramm, durchgezogene Linie). Daraus ist zu erkennen, dass keine Einsatzfähigkeit der Ansteuervorrichtung bzw. des Aktuators vorliegt.

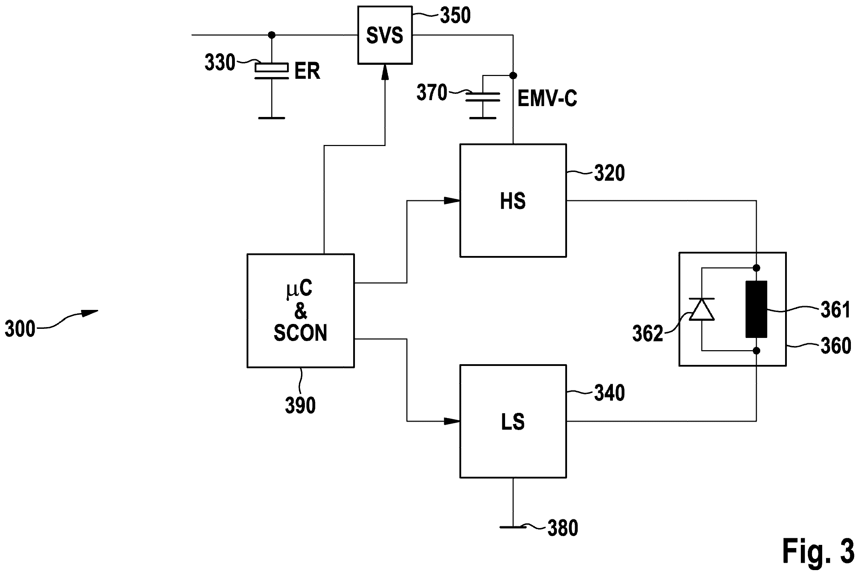

Fig. 3 zeigt ein Blockschaltbild einer erfindungsgemäßen Vorrichtung 300, die korrekt gepolt angeschlossen wurde.

Es sind abgebildet mit dem Bezugszeichen 330 eine Energiereserve (ER), mit dem Bezugszeichen 350 ein erster Schalter oder Sicherheitsschalter (SVS), mit dem Bezugszeichen 370 eine separate Energiequelle, hier als Kondensator für die Elektromagnetische-Verträglichkeit (EMV-C) der Vorrichtung 300, mit dem Bezugszeichen 390 eine Baugruppe mit einem Mikrokontroller (µC) und einem Sicherheitskontroller (SCON), sowie der benötigen externen Beschaltung, mit dem Bezugszeichen 320 ein zweiter Schalter oder High-Side Schalter (HS), mit dem Bezugszeichen 340 ein dritter Schalter oder Low-Side Schalter (LS), mit dem Bezugszeichen 360 ein Ansteuervorrichtung oder Aktuator, mit dem Bezugszeichen 380 ein Massepotential.

Die Ansteuervorrichtung bzw. der Aktuator 360 weist mindestens eine Spule 361 und eine Freilaufdiode 362, sowie weitere mechanischen Elemente, die zur Ansteuerung der Sicherheitseinrichtungen notwendig sind, auf.

Die Baugruppe 390 ist dazu ausgebildet, um den ersten Schalter bzw. Sicherheitsschalter (SVS) 350, den zweiten Schalter bzw. High-Side Schalter 320 und den dritten Schalter bzw. Low-Side Schalter 340 zu steuern.

In einer Ausgestaltung des erfindungsgemäßen Verfahrens wird zunächst der erste Schalter bzw. Sicherheitsschalter (SVS) 350 mittels der Baugruppe 390 geschlossen, um die separate Energiequelle 370, bspw. EMV-Kondensator zu laden. Wenn die separate Energiequelle 370, bspw.. der EMV-Kondensator aufgeladen ist, wird der erste Schalter bzw. Sicherheitsschalter (SVS) 350 geöffnet. Dadurch ist die Ansteuervorrichtung bzw. der Aktuator 360 nur noch über die separate Energiequelle 370, bspw. den EMV-Kondensator mit Spannung versorgbar. Danach wird mittels der Baugruppe 390 der zweite Schalter 320 geschlossen. Dadurch wird eine Spannung bereitgestellt von der separaten Energiequelle 370, bspw. dem EMV-Kondensator, an den Aktuator 360 angelegt. Mittels einem geeigneten und aus dem Stand der Technik bekannten Verfahren werden zeitgleich Spannungsverläufe an dem High-Side Schalter 320 und dem Low-Side Schalter 340 erfasst. Die erfassten Messwerte der Spannungsverläufe werden an den Mikrokontroller (µC) weitergeben. Die Auswertung erfolgt in dem Mikrokontroller (µC) in der Bauguppe 390 mittels geeignete Software oder Hardwareschaltung. Steigt der Spannungsverlauf am High-Side Schalter 320 schneller an, als der Spannungsverlauf an dem Low-Side Schalter 340, so kann erkannt werden, dass der Aktuator 360 korrekt gepolt eingebaut bzw. angeschlossen wurde und eine Einsatzfähigkeit des Aktuators 360 kann erkannt werden. Ist das nicht der Fall und der Spannungsverläufe an dem High-Side Schalter 320 und dem Low-Side Schalter 340 steigen gleich schnell an, so ist der Aktuator 360 verpolt eingebaut bzw. angeschlossen worden. Der Strom ist dabei nicht durch die Spule 361 sonder durch die Freilaufdiode 362 geflossen. Die Freilaufdiode 362 sperrt in diesem Fall nicht, da der Aktuator verpolt eingebaut bzw. angeschlossen wurde.

In dem Blockdiagramm ist zu erkennen, dass die Freilaufdiode 362 entgegengesetzt zur Stromflussrichtung ist. Wenn aufgrund einer angelegten Spannung Strom durch die Ansteuervorrichtung bzw. den Aktuator 360 fließt, dann fließt der Strom durch die Spule 361. Die Freilaufdiode 362 sperrt den Stromfluss.

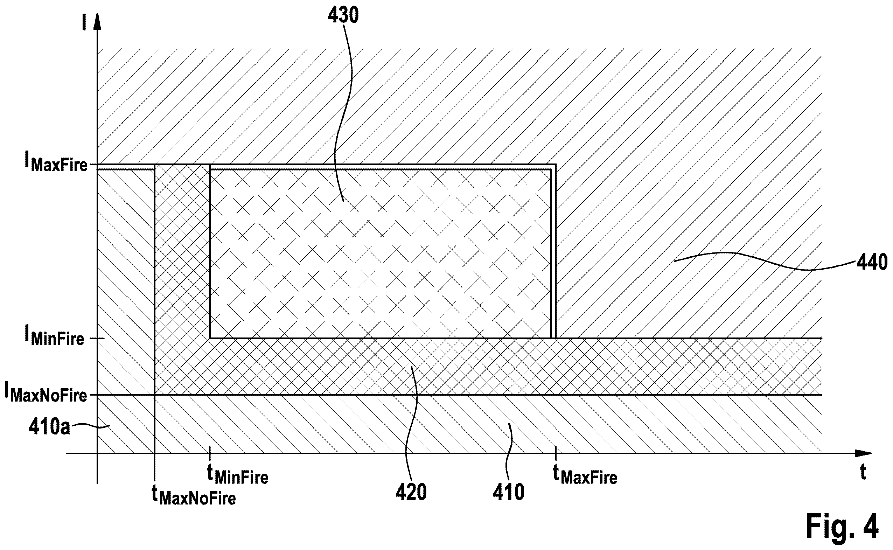

Fig. 4 zeigt ein Diagramm mit Grenzwerten für einen Strom für eine Ansteuervorrichtung 360 dieser Erfindung.

Auf der Abszisse ist die Zeit t aufgetragen. Auf der Ordinate der Strom I. Auf der Abszisse sind Grenzwerte für die Zeit aufgetragen. Auf der Ordinate sind Grenzwerte für einen Strom aufgetragen.

Der erste Grenzwert t_{MaxNoFire} auf der Abszisse bezeichnet eine maximale Zeitdauer, bevor eine Auslösung gesichert nicht stattfindet, auch wenn ein Strom durch den Aktuator 360 fließt, der zur minimal für eine Auslösung notwendig wäre. Der zweite Grenzwert t_{MinFire} bezeichnet eine minimale Zeitdauer, für einen minimalen Strom, der durch den Aktuator 360 fließen muss, damit es zu einer Auslösung kommt. Der dritte Grenzwert t_{MaxFire} bezeichnet eine maximale Zeitdauer für die ein minimaler Strom durch Aktuator 360 fließen darf ohne das es zu einer Zerstörung des Aktuators 360 kommen kann.

Der erste Grenzwert I_{MaxNoFire} auf der Ordinate bezeichnet einen maximalen Strom, der dauerhaft durch den Aktuator 360 fließen darf, ohne dass es zu einer Auslösung kommt. Der zweite Grenzwert I_{MinFire} bezeichnet einen minimalen Strom, der durch den Aktuator 360 fließen muss, damit es zu einer Auslösung kommen kann. Der dritte Grenzwert I_{MaxFire} bezeichnet einen maximalen Strom, der durch den Aktuator 360 fließen darf, ohne dass es zu einer Zerstörung des Aktuators 360 kommen kann.

Die sechs Grenzwerte spannen Bereiche auf. Der von links oben nach rechts unten schraffierte Bereich 410 bezeichnet einen Arbeitsbereich (nicht Auslöse-Bereich) des Aktuators in dem es zu keiner Auslösung kommen kann. Der gekreuzt schraffierte Bereich 420 bezeichnet einen Arbeitsbereich (Grau-Bereich) in dem es weder gesichert zu einer Auslösung kommt, noch gesichert zu keiner Auslösung kommt. Der gekrätet schraffierte Bereich 430 bezeichnet einen Arbeitsbereich (Auslösebereich), in dem es gesichert zu einer Auslösung des Aktuators 360 kommt. Der von links unten nach rechts oben schraffierte Bereich 440 bezeichnet einen Arbeitsbereich (Überlast-Bereich), in dem es zu einer Zerstörung des Aktuators 360 kommen kann. Der nicht Auslöse-Bereich 410 weist zudem noch einen Teilbereich 410a auf. In diesem Bereich läuft das erfindungsgemäße Verfahren ab bzw. arbeitet die erfindungsgemäße Vorrichtung 300 bei dem Ausführen des erfindungsgemäßen Verfahrens

Das erfindungsgemäße Verfahren läuft in dem Teilbereich 410a des Arbeitsbereichs 410 ab. Dadurch ist es gesichert, dass es bei Ablauf des erfindungsgemäßen Verfahrens zu keiner ungewollten Auslösung des Aktuators 360 kommen kann. Dazu ist beispielsweise die separate Energiequelle 370 entsprechend dimensioniert. Die Energiequelle kann nicht genug Energie bzw. Spannung bzw. Strom bereitstellen, um den Aktuator 360 in einem anderen Bereich als dem Teilbereich 410a des Arbeitsbereichs 410 zu betreiben.

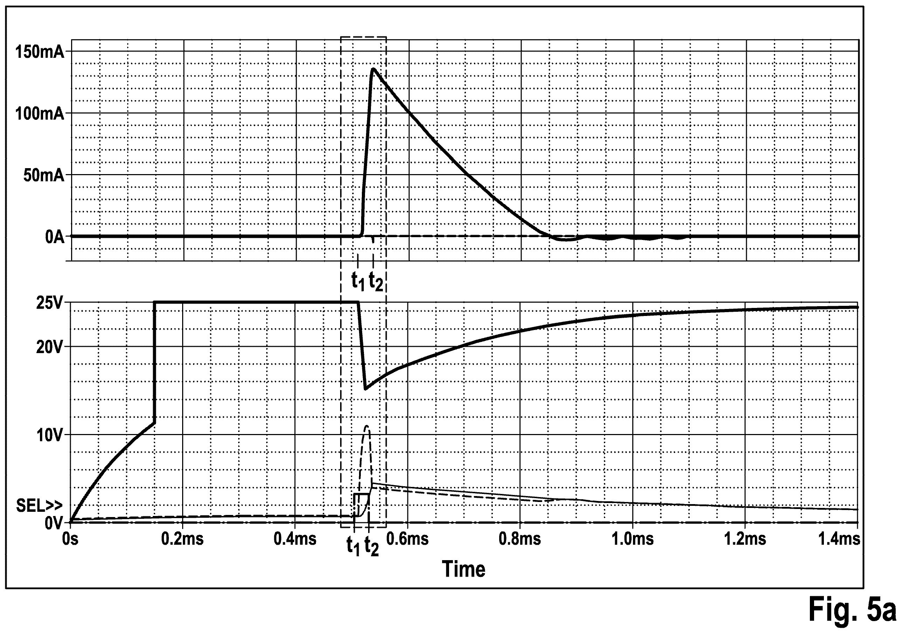

Fig. 5a zeigt ein Diagramm eines erfassten Spannungs- und Stromverlaufs bei Ablauf des erfindungsgemäßen Verfahrens mittels der erfindungsgemäßen Vorrichtung, wenn die Ansteuervorrichtung bzw. der Aktuator dieser Erfindung korrekt gepolt wurde.

Im oberen Diagramm sind die Stromverläufe über die Zeit durch die Ansteuervorrichtung bzw. den Aktuator und durch die Freilaufdiode aufgetragen. Die durchgezogene Linie gibt dabei den Stromverlauf durch die Ansteuervorrichtung bzw. den Aktuator wieder. Die gestrichelte Linie gibt dabei den Stromverlauf durch die Freilaufdiode wieder.

Im unteren Diagramm sind die Spannungsverläufe über die Zeit aufgetragen, die an der separaten Engeriequelle, beispielsweise einem EMV-Kodensator, dem zweiten Schalter (HS) bzw. dem High-Side Schalter abfallen, der Spannungsverlauf, der zur Ansteuerung lediglich des zweiten Schalters (HS) bzw. des High-Side Schalters notwendig ist, sowie der Spannungsverlauf, der an dem dritten Schalter (LS) bzw. dem Low-Side Schalter abfällt. Die dicke durchgezogene Linie gibt dabei den Spannungsverlauf an der separaten Energiequelle, beispielsweise einem EMV-Kondensator wieder, die gestrichelte Linie gibt dabei den Spannungsverlauf an dem zweiten Schalter (HS) bzw. dem High-Side Schalter wieder und die ge-punkt-strich-elte Linie gibt dabei den Spannungsverlauf zur Ansteuerung lediglich des zweiten Schalters (HS) bzw. High-Side Schalters durch eine Verarbeitungseinrichtung (µC) wieder. Die dünne durchgezogene Linie gibt dabei den Spannungsverlauf, der an dem dritten Schalter (LS) bzw. dem Low-Side Schalter abfällt wieder.

Es ist deutlich zu erkennen, dass zum Zeitpunkt t1 des Anlegens einer Spannung ein Spannungsanstieg im Spannungsverlauf an dem High-Side Schalter (HS) stattfindet. Ein Spannungsanstieg im Spannungsverlauf an dem Low-Side Schalter (LS) findet langsamer statt. Gleichzeit ist zu erkennen, dass ein Strom beginnt durch den Aktuator zu fließen. Der Strom durch die Freilaufdiode zeigt keinen nennenswerten Wert. Daraus ist die Einsatzfähigkeit der Ansteuervorrichtung bzw. des Aktuators erkannt.

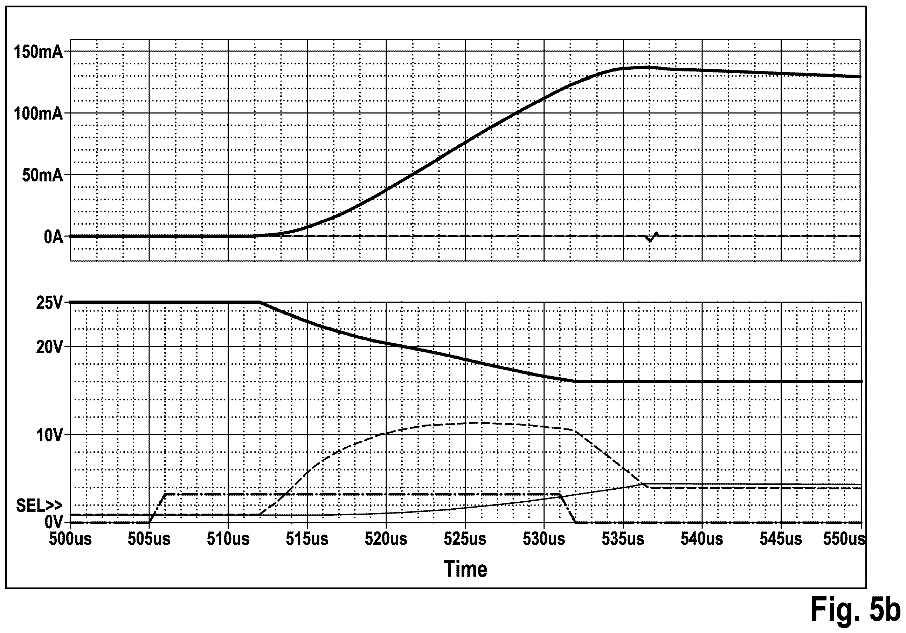

Die Fig. 5b zeigt einen vergrößerten Ausschnitt um den Bereich um die Zeitpunkte t1 und t2. Hier sind die Spannungsanstiege in den Spannungsverläufen an dem High-Side Schalter (HS) und dem Low-Side Schalter (LS) noch deutlicher zu erkennen.

In Fig. 5b ist deutlich zu erkennen, dass der Spannungsanstieg an dem Low-Side Schalter (LS) langsamer stattfindet als an dem High-Side Schalter (HS). Der Aktuator ist demnach einsatzbereit. Da der Strom durch die Spule des Aktuators fließen kann.

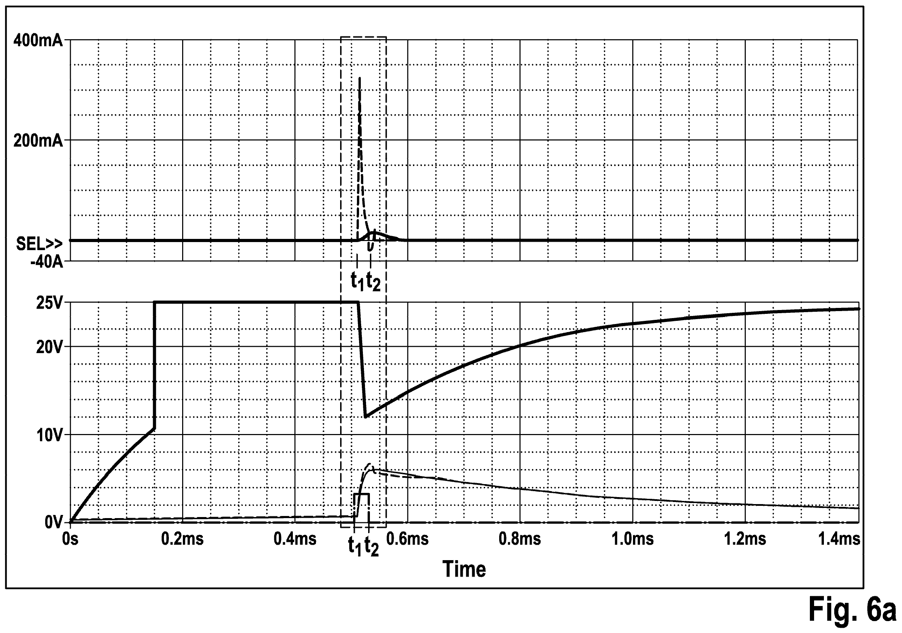

Fig. 6a zeigt ein Diagramm eines erfassten Spannungs- und Stromverlaufs bei Ablauf des erfindungsgemäßen Verfahrens mittels der erfindungsgemäßen Vorrichtung, wenn die Ansteuervorrichtung bzw. der Aktuator dieser Erfindung fehlerhaft gepolt bzw verpolt wurde.

Im oberen Diagramm sind die Stromverläufe über die Zeit durch die Ansteuervorrichtung bzw. den Aktuator und durch die Freilaufdiode aufgetragen. Die durchgezogene Linie gibt dabei den Stromverlauf durch die Ansteuervorrichtung bzw. den Aktuator wieder. Die gestrichelte Linie gibt dabei den Stromverlauf durch die Freilaufdiode wieder.

Im unteren Diagramm sind die Spannungsverläufe über die Zeit aufgetragen, die an der separaten Engeriequelle, beispielsweise einem EMV-Kodensator, dem zweiten Schalter (HS) bzw. dem High-Side Schalter abfallen, der Spannungsverlauf, der zur Ansteuerung lediglich des zweiten Schalters (HS) bzw. des High-Side Schalters notwendig ist, sowie der Spannungsverlauf, der an dem dritten Schalter (LS) bzw. dem Low-Side Schalter abfällt. Die dicke durchgezogene Linie gibt dabei den Spannungsverlauf an der separaten Energiequelle, beispielsweise einem EMV-Kondensator wieder, die gestrichelte Linie gibt dabei den Spannungsverlauf an dem zweiten Schalter (HS) bzw. dem High-Side Schalter wieder und die ge-punkt-strich-elte Linie gibt dabei den Spannungsverlauf zur Ansteuerung lediglich des zweiten Schalters (HS) bzw. High-Side Schalters durch eine Verarbeitungseinrichtung (µC) wieder. Die dünne durchgezogene Linie gibt dabei den Spannungsverlauf, der an dem dritten Schalter (LS) bzw. dem Low-Side Schalter abfällt wieder.

Es ist deutlich zu erkennen, dass zum Zeitpunkt t1 des Anlegens einer Spannung ein Spannungsanstieg im Spannungsverlauf an dem High-Side Schalter (HS) stattfindet. Gleichzeit findet ein gleichschneller bzw. quasi gleichschneller Spannungsanstieg im Spannungsverlauf an dem Low-Side Schalter (LS) statt. Gleichzeit ist zu erkennen, dass ein Strom beginnt durch die Freilaufdiode zu fließen. Der Strom durch die Ansteuervorrichtung bzw. den Aktuator zeigt keinen nennenswerten Wert. Daraus ist zu erkennen, dass keine Einsatzfähigkeit der Ansteuervorrichtung bzw. des Aktuators vorliegt.

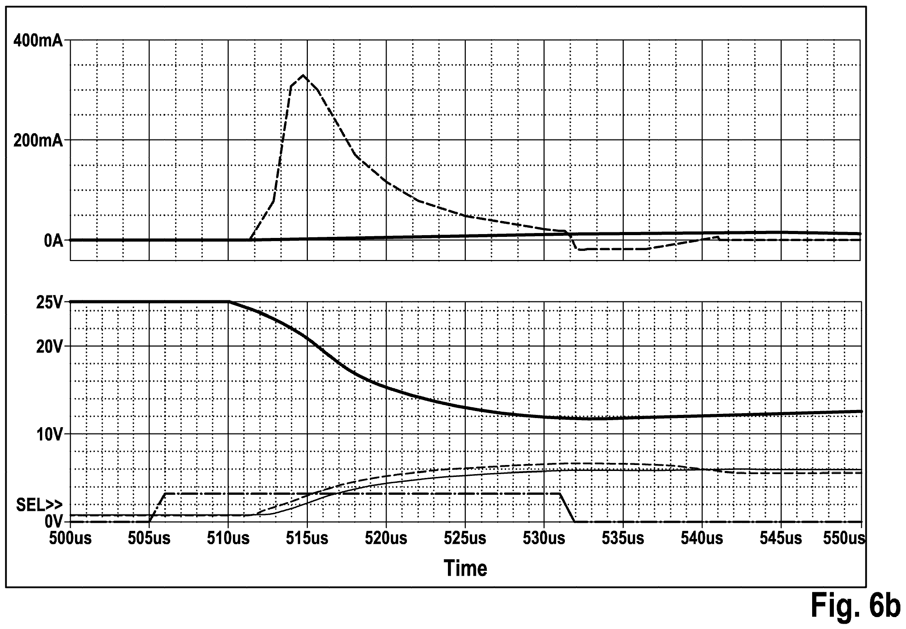

Die Fig. 6b zeigt einen vergrößerten Ausschnitt um den Bereich um die Zeitpunkte t1 und t2. Hier sind die Spannungsanstiege in den Spannungsverläufen an dem High-Side Schalter (HS) und dem Low-Side Schalter (LS) noch deutlicher zu erkennen.

In Fig. 6b ist deutlich zu erkennen, dass der Spannungsanstieg an dem Low-Side Schalter (LS) und an dem High-Side Schalter (HS) gleichschnell bzw. quasi gleichschnell stattfinden. Der Aktuator ist demnach nicht einsatzbereit, da der Strom durch die Freilaufdiode des Aktuators fließen kann.

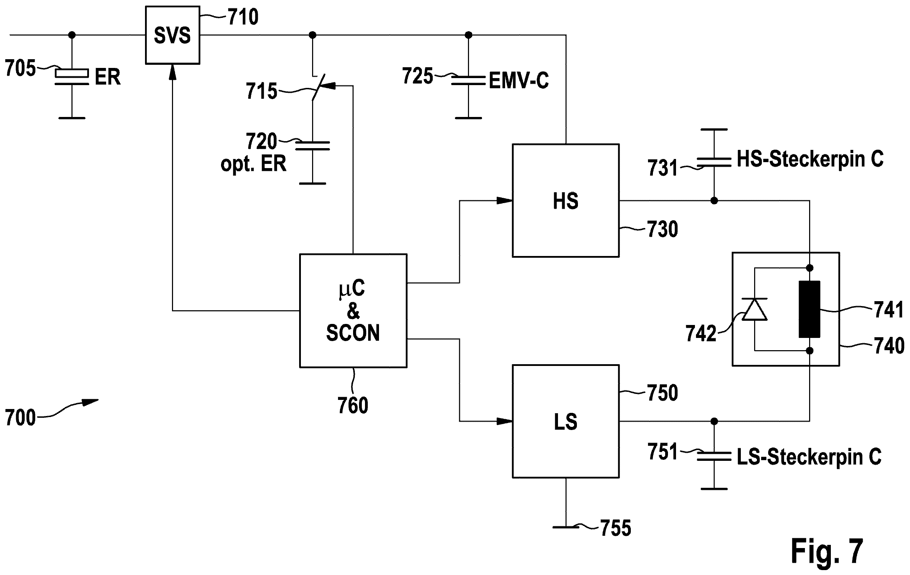

Fig. 7 zeigt ein Blockschaltbild einer alternativen Ausführungsform einer erfindungsgemäßen Vorrichtung 700, die korrekt gepolt angeschlossen wurde.

Es sind abgebildet mit dem Bezugszeichen 705 eine Energiereserve (ER), mit dem Bezugszeichen 710 ein erster Schalter oder Sicherheitsschalter (SVS), mit dem Bezugszeichen 715 ein weiterer Schalter für eine weitere optionale Energiequelle, mit dem Bezugszeichen 720 eine weitere optionale Energiequelle, mit dem Bezugszeichen 725 ein Kondensator zur Realisierung einer EMV-Verträglichkeit der Vorrichtung 700, ein sogenannter EMV-Kondensator, mit dem Bezugszeichen 730 ein zweiter Schalter bzw. High-Side Schalter, mit dem Bezugszeichen 731 eine Kapazität des High-Side Schalters, mit dem Bezugszeichen 740 ein Aktuator, mit dem Bezugszeichen 741 eine Spule des Aktuators, mit dem Bezugszeichen 742 ein Freilaufdiode des Aktuators, mit dem Bezugszeichen 751 eine Kapazität des Low-Side Schalters, mit dem Bezugszeichen 750 ein dritter Schalter oder Low-Side Schalter, mit dem Bezugszeichen 755 ein Massepotential, mit dem Bezugszeichen 760 eine Baugruppe mit mindestens einem Mikrokontroller (µC) und einem Sicherheitskontroller (SCON), sowie der benötigen externen Beschaltung.

Obwohl die Kapazitäten des High-Side Schalters 731 und des Low-Side Schalters 751 separat dargestellt sind, können die Kapazitäten Teil der jeweiligen Schalter sein bzw. Teil der Vorrichtung 700, wenn die Schalter 730, 750 bzw. die Vorrichtung 700 beispielsweise als integrierte Schaltkreise (ASIC) ausgebildet sind.

Die Baugruppe 760 ist dazu ausgebildet, um den ersten Schalter bzw. Sicherheitsschalter (SVS) 710, den weiteren Schalter 715 für eine weitere optionale Energiequelle 720, den High-Side Schalter 730 und den Low-Side Schalter 750 zu steuern.

In der alternativen Ausführungsform der erfindungsgemäßen Vorrichtung 700 nach Fig. 7 ist die separate Energiequelle über eine weitere optionale Energiequelle 715 realisiert worden. Zur Durchführung des erfindungsgemäßen Verfahrens wird mittels der Baugruppe 760, also mittels des Mikrokontrollers (µC) oder mittels des Sicherheitskontrollers (SCON) über den Schalter 715 Energie zur Verfügung gestellt bzw. Spannung an den Aktuator 740 angelegt.

Der Spannungsverlauf kann dann an den Kapazitäten des High-Side Schalters 731 und Low-Side Schalters 751 erfasst werden.

In einer nicht explizit dargestellten Ausführungsform der erfindungsgemäßen Vorrichtung wird die separate Energiequelle ausschließlich von dem Kondensator für die EMV-Verträglichkeit 370, 725 realisiert. In einer solchen Ausführungsform weist die erfindungsgemäße Vorrichtung keine optionale weitere Energiequelle 330, 720 und auch keinen Schalter für die optionale weitere Energiequelle 715 auf.

Die Ansteuerung für die schaltbaren Elemente Sicherheitsschalter (SVS), High-Side Schalter (HS) und Low-Side Schalter (LS) sowie für die optionale weitere Energiereserve 720 können sowohl durch den Mikrokontroller (µC) unter Zuhilfenahme von Software, also einem geeigneten Programm, das auf einem geeigneten Datenträger gespeichert wurde, sowie komplett hardwaregesteuert mittels geeigneter Hardware-Logik, beispielsweise mittels dem Sicherheitskontroller (SCON), einem zweiten (Sicherheits-)Mikrokontroller, FPGA, PAL, GAL, etc. erfolgen.

Eine gemischte Ansteuerung ist ebenfalls möglich. Dabei steuert der Mikrokontroller (µC) beispielsweise den Sicherheitsschalter (SVS) 710 und die optionale weitere Energiereserve 330, 720 mittels Software. Die High-Side Schalter (HS) 320, 730 und Low-Side Schalter (LS) 340, 750 werden über einen separaten Hardware-Pfad beispielsweise über den Sicherheitskontroller (SCON) kontrolliert.

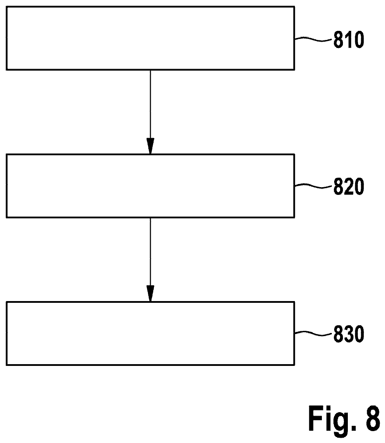

Fig. 8 zeigt ein Ablaufdiagramm des erfindungsgemäßen Verfahrens.

In Schritt 810 erfolgt das Anlegen einer Spannung an die Ansteuervorrichtung 360, 740.

In Schritt 820 erfolgt das Erfassen eines Spannungsverlaufs bzw. Stromverlaufs an der Ansteuervorrichtung 360, 740. Beispielsweise durch das Erfassen eines Spannungsverlaufs an dem High-Side Schalter (HS) 320, 730 und dem Low-Side Schalter 340, 750.

In Schritt 830 erfolgt das Erkennen einer Einsatzfähigkeit der Ansteuervorrichtung 360, 740 abhängig von dem erfassten Spannungsverlauf bzw. Stromverlauf. Beispielsweise kann durch den Verlauf des Spannungsverlaufs, insbesondere durch einen Spannungsanstieg an dem High-Side Schalter (HS) 320, 730, der schneller abläuft, als ein Spannungsverlauf, insbesondere als ein Spannungsanstieg an dem Low-Side Schalter (LS) 340, 750, erkannt werden, dass die Ansteuervorrichtung 360, 740 korrekt gepolt eingebaut bzw. eingesetzt wurde und damit einsatzfähig ist.

Führt das erfindungsgemäße Verfahren zu dem Ergebnis, dass die Ansteuervorrichtung bzw. der Aktuator nicht einsatzfähig ist, dann kann dass Verfahren bis zur Fehlerqualifikation mehrfach wiederholt werden. Unter einer Fehlerqualifikation kann vorliegend verstanden werden, dass ein Fehlereintrag in einem Fehlerspeicher erfolgt bzw. eine Warnlampe angesteuert wird, um dem Fahrer zu signalisieren, dass die Sicherheitseinrichtungen im Fahrzeug nicht vollständig einsatzfähig sind.

## Patentansprüche

1. Vorrichtung (300, 700) zum Erkennen einer Einsatzfähigkeit einer Ansteuervorrichtung (360, 740) mit einer Vorzugsstromrichtung für eine Sicherheitseinrichtung in einem Fahrzeug, wobei die Ansteuervorrichtung (360, 740)
mindestens ein elektrisches Bauteil (361, 741) aufweist, wobei das Bauteil (361, 741) einen induktiven Charakter aufweist, wobei die Vorrichtung (300, 700)
Mittel (760, 730, 750) zum Anlegen einer Spannung an die Ansteuervorrichtung (360, 740);
Mittel (760, 731, 751) zum Erfassen eines Spannungsverlaufs an der Ansteuervorrichtung (360, 740);
Mittel (760) zum Erkennen einer Einsatzfähigkeit der Ansteuervorrichtung (360, 740) abhängig von dem erfassten Spannungsverlauf aufweist, wobei die Einsatzfähigkeit der Ansteuervorrichtung (360, 740) der Sicherheitseinrichtung eine korrekte Polung der Ansteuervorrichtung (360, 740) ist, wobei
die Ansteuervorrichtung (360, 740) einen Grenzwert (t_{MaxNoFire}) für eine Zeit aufweist und / oder einen Grenzwert (I_{MaxNoFire}) für einen Strom aufweist, wobei
die Ansteuervorrichtung (360, 740) nicht auslöst, wenn eine Spannung an die Ansteuervorrichtung (360, 740) für maximal eine Zeit angelegt wird, die dem Grenzwert (t_{MaxNoFire}) für eine Zeit entspricht und
die Ansteuervorrichtung (360, 740) nicht auslöst, wenn durch die Ansteuervorrichtung (360, 740) ein Strom fließt, der maximal dem Grenzwert (I_{MaxNoFire}) für einen Strom entspricht, wobei
die Vorrichtung (300, 700) eine separate Energiequelle (370, 720, 725) zum Bereitstellen einer Spannung zum Anlegen an die Ansteuervorrichtung (360, 740) aufweist, wobei die separate Energiequelle (370, 720, 725) eine Kapazität aufweist, wobei
die Kapazität maximal so viel Energie speichern kann, dass die Spannung für maximal eine Zeit an die Ansteuervorrichtung (360, 740) angelegt werden kann, die dem Grenzwert (t_{MaxNoFire}) für eine Zeit entspricht und / oder
die Spannung maximal solange angelegt werden kann, bis ein Strom fließt, der dem Grenzwert (I_{MaxNoFire}) für einen Strom entspricht.

2. Vorrichtung (300, 700) nach Anspruch 1, wobei
das Fahrzeug eine weitere Energiequelle aufweist, wobei
die Vorrichtung (300, 700) einen erster Schalter (350, 710) aufweist, wobei die separate Energiequelle (370, 720, 725) durch einen ersten Schalters (350, 710) mit der weiteren Energiequelle des Fahrzeugs verbindbar ist, wobei
die Vorrichtung die separate Energiequelle (370, 720, 725) durch Verbinden mit der weiteren Energiequelle des Fahrzeugs mittels des ersten Schalters (350, 710), insbesondere durch Schließen des ersten Schalters (350, 710), lädt.

3. Vorrichtung (300, 700) nach Anspruch 2, wobei
die Vorrichtung (300, 700) die weitere Energiequelle des Fahrzeugs mittels des ersten Schalters (350, 710), insbesondere durch Öffnen des Schalters, trennt.

4. Vorrichtung (300, 700) nach Anspruch 1 bis 3, wobei
die Ansteuervorrichtung (360, 740) mindestens einen zweiten Schalter (320, 730) und mindestens einen dritten Schalter (340, 750) aufweist, wobei
zum Ansteuern der Sicherheitseinrichtung (300, 700) der mindestens eine zweite Schalter (320, 730) und der mindestens eine dritte Schalter (320, 750) geschlossen werden, wobei
die Mittel (760, 730, 750) zum Anlegen einer Spannung zum Anlegen der Spannung den mindestens einen zweiten Schalter (320, 730) schließen und den mindestens einen dritten Schalter (340, 750) nicht schließen.

5. Vorrichtung (300, 700) nach Anspruch 1 bis 4, wobei
die separate Energiequelle (370, 720, 725) zwischen dem ersten Schalter (350, 710) und dem mindestens einen zweiten Schalter (320, 730) angeordnet ist.

6. Verfahren (800) zum Erkennen einer Einsatzfähigkeit einer Ansteuervorrichtung (360, 740) einer Sicherheitseinrichtung mit einer Vorrichtung nach einem der Ansprüche 1 bis 5 in einem Fahrzeug mit den Schritten:
Anlegen (810) einer Spannung an die Ansteuervorrichtung (360, 740) Erfassen (820) eines Spannungsverlaufs und/oder Stromverlaufs an der Ansteuervorrichtung (360, 740)
Erkennen (830) einer Einsatzfähigkeit der Ansteuervorrichtung (360, 740) abhängig von dem erfassten Spannungsverlauf und/oder Stromverlauf, wobei die Einsatzfähigkeit der Ansteuervorrichtung (360, 740) der Sicherheitseinrichtung eine korrekte Polung der Ansteuervorrichtung (360, 740) ist.

7. Verfahren (800) nach Anspruch 6, wobei
im Schritt des Anlegens (810) eine Spannung aus einer separaten Energiequelle (370, 720, 725) angelegt wird, mit einem weiteren Schritt:
Laden der separaten Energiequelle (370, 720, 725).

8. Verfahren (800) nach Anspruch 7, wobei
das Fahrzeug eine weitere Energiequelle (720) aufweist, wobei
die separate Energiequelle (370 720, 725) durch einen ersten Schalter (350, 710) mit der weiteren Energiequelle des Fahrzeugs verbindbar ist, wobei
im Schritt des Ladens die separate Energiequelle (370, 720, 725) durch Verbinden mit der weiteren Energiequelle des Fahrzeugs mittels des ersten Schalters (350, 710), insbesondere durch Schließen des ersten Schalters (350, 710), geladen wird.

9. Verfahren (800) nach Anspruch 8, wobei
im Schritt des Ladens nach dem Aufladen der separaten Energiequelle (370, 720, 725) die Verbindung zur weiteren Energiequelle des Fahrzeugs mittels des ersten Schalters (350, 710), insbesondere durch Öffnen des ersten Schalters (350, 710), getrennt wird.

10. Verfahren (800) nach einem Ansprüche 6 bis 9,
wobei
die Ansteuervorrichtung (360, 740) eine Grenzwert (t_{MaxNoFire}) für eine Zeit aufweist und / oder einen Grenzwert (I_{MaxNoFire}) für einen Strom aufweist, wobei
die Ansteuervorrichtung (360, 740) nicht auslöst, wenn eine Spannung an die Ansteuervorrichtung (360, 740) für maximal eine Zeit angelegt wird, die dem Grenzwert (t_{MaxNoFire}) für eine Zeit entspricht und
die Ansteuervorrichtung (360, 740) nicht auslöst, wenn durch die Ansteuervorrichtung (360, 740) ein Strom fließt, der maximal dem Grenzwert (I_{MaxNoFire}) für einen Strom entspricht, wobei
das Verfahren (800) einen weiteren Schritt aufweist:
Trennen der angelegten Spannung, nach maximal der Zeit, die dem Grenzwert (t_{MaxNoFire}) für ein Zeit entspricht oder bevor ein Strom fließt, der dem Grenzwert (I_{MaxNoFire}) für einen Strom entspricht.

11. Verfahren (800) nach einem der Ansprüche 6 bis 10, wobei
im Schritt des Erkennens (830) die Einsatzfähigkeit dann erkannt wird, wenn der erfasste Spannungsverlauf einen charakteristischen Spannungsanstieg aufweist.

12. Verfahren (800) nach Anspruch 12, wobei
im Schritt des Erkennens (830) der erfasste Spannungsverlauf mit einem Grenzwert(u_{Grenz}) für eine Spannung verglichen wird.

13. Verfahren (800) nach einem der Ansprüche 6 bis 12, wobei
die Ersatzfähigkeit als nicht gegeben erkannt wird, wenn der erfasste Spannungsverlauf keinen charakteristischen Spannungsanstieg aufweist.

14. Verfahren (800) nach einem der Ansprüche 6 bis 13, wobei
eine Einsatzfähigkeit der Ansteuervorrichtung (360, 740) der Sicherheitseinrichtung eine korrekte Polung der Ansteuervorrichtung (360, 740) ist.

15. Verfahren (800) nach einem der Ansprüche 6 bis 14, wobei
an die Ansteuervorrichtung (360, 740) mittels mindestens eines zweiten Schalters (320, 730) die Spannung anlegbar ist, wobei
im Schritt des Anlegens (810) mittels des mindestens einen zweiten Schalters (320, 730) eine Spannung angelegt wird, insbesondere der mindestens eine zweite Schalter (320, 730) geschlossen wird.

16. Verfahren (800) nach Anspruch 15, wobei
die Ansteuervorrichtung (360, 740) mittels des mindestens eine zweite Schalters (320, 730) und eines mindestens dritten Schalters (340, 750) auslösbar ist, wobei
im Schritt des Anlegens (810) mittels des mindestens einen dritten Schalters (340, 750) eine Auslösung unterbunden wird, insbesondere der mindestens eine dritte Schalter nicht geschlossen wird.

## Claims

1. Apparatus (300, 700) for detecting usability of a control apparatus (360, 740) with a preferential current direction for a safety device in a vehicle, the control apparatus (360, 740) having
at least one electrical component (361, 741), the component (361, 741) having an inductive nature, the apparatus (300, 700) having
means (760, 730, 750) for applying a voltage to the control apparatus (360, 740);
means (760, 731, 751) for recording a voltage profile at the control apparatus (360, 740);
means (760) for detecting usability of the control apparatus (360, 740) on the basis of the recorded voltage profile, the usability of the control apparatus (360, 740) of the safety device being a correct polarity of the control apparatus (360, 740),
the control apparatus (360, 740) having a limit value (t_{MaxNoFire}) for a time and/or a limit value (I_{MaxNoFire}) for a current,
the control apparatus (360, 740) not firing if a voltage is applied to the control apparatus (360, 740) for at most a time which corresponds to the limit value (t_{MaxNoFire}) for a time, and
the control apparatus (360, 740) not firing if a current which corresponds at most to the limit value (I_{MaxNoFire}) for a current flows through the control apparatus (360, 740),
the apparatus (300, 700) having a separate energy source (370, 720, 725) for providing a voltage for application to the control apparatus (360, 740), the separate energy source (370, 720, 725) having a capacitance,
the capacitance being able to store at most so much energy that the voltage can be applied to the control apparatus (3.60, 740) for at most a time which corresponds to the limit value (t_{MaxNoFire}) for a time and/or
the voltage can be applied at most until a current corresponding to the limit value (I_{MaxNoFire}) for a current flows.

2. Apparatus (300, 700) according to Claim 1,
the vehicle having a further energy source,
the apparatus (300, 700) having a first switch (350, 710), the separate energy source (370, 720, 725) being able to be connected to the further energy source of the vehicle by means of a first switch (350, 710),
the apparatus charging the separate energy source (370, 720, 725) by means of connection to the further energy source of the vehicle by means of the first switch (350, 710), in particular by closing the first switch (350, 710).

3. Apparatus (300, 700) according to Claim 2,
the apparatus (300, 700) disconnecting the further energy source of the vehicle by means of the first switch (350, 710), in particular by opening the switch.

4. Apparatus (300, 700) according to Claims 1 to 3,
the control apparatus (360, 740) having at least one second switch (320, 730) and at least one third switch (340, 750),
the at least one second switch (320, 730) and the at least one third switch (320, 750) being closed in order to control the safety device (300, 700),
the means (760, 730, 750) for applying a voltage closing the at least one second switch (320, 730) and not closing the at least one third switch (340, 750) in order to apply the voltage.

5. Apparatus (300, 700) according to Claims 1 to 4,
the separate energy source (370, 720, 725) being arranged between the first switch (350, 710) and the at least one second switch (320, 730).

6. Method (800) for detecting usability of a control apparatus (360, 740) of a safety device with an apparatus according to one of Claims 1 to 5 in a vehicle, having the steps of:
applying (810) a voltage to the control apparatus (360, 740),
recording (820) a voltage profile and/or current profile at the control apparatus (360, 740),
detecting (830) usability of the control apparatus (360, 740) on the basis of the recorded voltage profile and/or current profile, the usability of the control apparatus (360, 740) of the safety device being a correct polarity of the control apparatus (360, 740).

7. Method (800) according to Claim 6,
a voltage from a separate energy source (370, 720, 725) being applied in the application step (810), with a further step of:
charging the separate energy source (370, 720, 725).

8. Method (800) according to Claim 7,
the vehicle having a further energy source (720),
the separate energy source (370, 720, 725) being able to be connected to the further energy source of the vehicle by means of a first switch (350, 710),
the separate energy source (370, 720, 725) being charged in the charging step by means of connection to the further energy source of the vehicle by means of the first switch (350, 710), in particular by closing the first switch (350, 710).

9. Method (800) according to Claim 8,
the connection to the further energy source of the vehicle being disconnected by means of the first switch (350, 710), in particular by opening the first switch (350, 710), in the charging step after charging the separate energy source (370, 720, 725).

10. Method (800) according to one of Claims 6 to 9,
the control apparatus (360, 740) having a limit value (t_{MaxNoFire}) for a time and/or a limit value (I_{MaxNoFire}) for a current,
the control apparatus (360, 740) not firing if a voltage is applied to the control apparatus (360, 740) for at most a time which corresponds to the limit value (t_{MaxNoFire}) for a time, and
the control apparatus (360, 740) not firing if a current which corresponds at most to the limit value (I_{MaxNoFire}) for a current flows through the control apparatus (360, 740),
the method (800) having a further step of:
disconnecting the applied voltage after at most the time corresponding to the limit value (t_{MaxNoFire}) for a time or before a current corresponding to the limit value (I_{MaxNoFire}) for a current flows.

11. Method (800) according to one of Claims 6 to 10,
the usability being detected in the detection step (830) if the recorded voltage profile has a characteristic voltage rise.

12. Method (800) according to Claim 12,
the recorded voltage profile being compared with a limit value (u_{Grenz}) for a voltage in the detection step (830).

13. Method (800) according to one of Claims 6 to 12,
the usability being detected as not being present if the recorded voltage profile does not have a characteristic voltage rise.

14. Method (800) according to one of Claims 6 to 13, usability of the control apparatus (360, 740) of the safety device being a correct polarity of the control apparatus (360, 740).

15. Method (800) according to one of Claims 6 to 14,
the voltage being able to be applied to the control apparatus (360, 740) by means of at least one second switch (320, 730),
a voltage being applied in the application step (810) by means of the at least one second switch (320, 730), in particular the at least one second switch (320, 730) being closed.

16. Method (800) according to Claim 15,
the control apparatus (360, 740) being able to be fired by means of the at least one second switch (320, 730) and one at least third switch (340, 750), firing being prevented in the application step (810) by means of the at least one third switch (340, 750), in particular the at least one third switch not being closed.

## Revendications

1. Dispositif (300, 700) pour identifier une disponibilité opérationnelle d'un dispositif de commande (360, 740) ayant un sens de passage préféré du courant pour un dispositif de sécurité dans un véhicule, dans lequel le dispositif de commande (360, 740) comporte au moins un composant électrique (361, 741), dans lequel le composant (361, 741) présente un caractère inductif, dans lequel le dispositif (300, 700) comporte
des moyens (760, 730, 750) pour appliquer une tension au dispositif de commande (360, 740) ;
des moyens (760, 731, 751) pour détecter une évolution de la tension sur le dispositif de commande (360, 740) ;
des moyens (760) pour identifier une disponibilité opérationnelle du dispositif de commande (360, 740) en fonction de l'évolution détectée de la tension, dans lequel la disponibilité opérationnelle du dispositif de commande (360, 740) du dispositif de sécurité est une polarité correcte du dispositif de commande (360, 740), dans lequel
le dispositif de commande (360, 740) présente une valeur limite (t_{MaxNoFire}) pour un temps et/ou une valeur limite (I_{MaxNoFire}) pour un courant, dans lequel
le dispositif de commande (360, 740) ne se déclenche pas lorsqu'une tension est appliquée au dispositif de commande (360, 740) au maximum pour un temps qui correspond à la valeur limite (t_{MaxNoFire}) pour un temps, et
le dispositif de commande (360, 740) ne se déclenche pas lorsqu'un courant passant à travers le dispositif de commande (360, 740) correspond au maximum à la valeur limite (I_{MaxNoFire}) pour un courant, dans lequel
le dispositif (300, 700) comporte une source d'énergie séparée (370, 720, 725) pour fournir une tension destinée à être appliquée au dispositif de commande (360, 740), dans lequel la source d'énergie séparée (370, 720, 725) comporte une capacité,
dans lequel la capacité peut au maximum stocker suffisamment d'énergie pour que la tension puisse être appliquée au maximum au dispositif de commande (360, 740) pour un temps qui correspond à la valeur limite (t_{MaxNoFire}) pour un temps, et/ou
la tension peut être appliquée au maximum tant qu'un courant passe, celui-ci correspondant à la valeur limite (I_{MaxNOFire}) pour un courant.

2. Dispositif (300, 700) selon la revendication 1, dans lequel
le véhicule comporte une autre source d'énergie, dans lequel
le dispositif (300, 700) comporte un premier commutateur (350, 710), dans lequel la source d'énergie séparée (370, 720, 725) peut être connectée par l'intermédiaire d'un premier commutateur (350, 710) à l'autre source d'énergie du véhicule, dans lequel
le dispositif charge la source d'énergie séparée (370, 720, 725) par connexion à l'autre source d'énergie du véhicule au moyen du premier commutateur (350, 710), notamment par fermeture du premier commutateur (350, 710).

3. Dispositif (300, 700) selon la revendication 2, dans lequel
le dispositif (300, 700) sépare l'autre source d'énergie du véhicule au moyen du premier commutateur (350, 710), notamment par ouverture du commutateur.

4. Dispositif (300, 700) selon les revendications 1 à 3, dans lequel
le dispositif (360, 740) comporte au moins un deuxième commutateur (320, 730) et au moins un troisième commutateur (340, 750), dans lequel
pour commander le dispositif de sécurité (300, 700), l'au moins un deuxième commutateur (320, 730) et l'au moins un troisième commutateur (320, 750) sont fermés, dans lequel
les moyens (760, 730, 750) destinés à appliquer une tension ferment l'au moins un deuxième commutateur (320, 730) et ne ferment pas l'au moins un troisième commutateur (340, 750) pour appliquer la tension.

5. Dispositif (300, 700) selon les revendications 1 à 4, dans lequel
la source d'énergie séparée (370, 720, 725) est disposée entre le premier commutateur (350, 710) et l'au moins un deuxième commutateur (320, 730).

6. Procédé (800) pour détecter une disponibilité opérationnelle d'un dispositif de commande (360, 740) d'un dispositif de sécurité comportant un dispositif selon l'une quelconque des revendications 1 à 5, dans un véhicule, comprenant les étapes consistant à :
appliquer (810) une tension au dispositif de commande (360, 740),
obtenir (820) une évolution de la tension et/ou une évolution du courant sur le dispositif de commande (360, 740) ;
détecter (830) une disponibilité opérationnelle du dispositif de commande (360, 740) en fonction de l'évolution de tension et/ou de l'évolution de courant détectée, dans lequel la disponibilité opérationnelle du dispositif de commande (360, 740) du dispositif de sécurité est une polarité correcte du dispositif de commande (360, 740).

7. Procédé (800) selon la revendication 6, dans lequel,
lors de l'étape d'application (810), une tension provenant d'une source d'énergie séparée (370, 720, 725) est appliquée, le procédé comportant une étape supplémentaire consistant à :
charger la source d'énergie séparée (370, 720, 725).

8. Procédé (800) selon la revendication 7, dans lequel,
le véhicule comporte une autre source d'énergie (720), dans lequel
la source d'énergie séparée (370, 720, 725) peut être connectée par l'intermédiaire d'un premier commutateur (350, 710) à l'autre source d'énergie du véhicule, dans lequel
lors de l'étape de charge, la source d'énergie séparée (370, 720, 725) peut être chargée par connexion à l'autre source d'énergie du véhicule au moyen du premier commutateur (350, 710), notamment par fermeture du premier commutateur (350, 710).

9. Procédé (800) selon la revendication 8, dans lequel,
lors de l'étape de charge, après que la source d'énergie séparée (370, 720, 725) a été chargée, la connexion à l'autre source d'énergie du véhicule est interrompue au moyen du premier commutateur (350, 710), notamment par ouverture du premier commutateur (350, 710).

10. Procédé (800) selon l'une quelconque des revendications 6 à 9, dans lequel,
le dispositif de commande (360, 740) présente une valeur limite (t_{MaxNoFire}) pour un temps et/ou présente une valeur limite (I_{MaxNoFire}) pour un courant, dans lequel
le dispositif de commande (360, 740) ne se déclenche pas lorsqu'une tension appliquée au dispositif de commande (360, 740) au maximum pour un temps correspond à la valeur limite (t_{MaxNoFire}) pour un temps, et
le dispositif de commande (360, 740) ne se déclenche pas lorsqu'un courant passant à travers le dispositif de commande (360, 740) correspond au maximum à la valeur limite (I_{MaxNoFire}) pour un courant, dans lequel
le procédé (800) comporte une autre étape consistant à :
interrompre l'application de la tension, au maximum après, e temps qui correspond à la valeur limite (t_{MaxNoFire}) pour un temps ou avant le passage d'un courant qui correspond à la valeur limite (I_{MaxNoFire}) pour un courant.

11. Procédé (800) selon l'une quelconque des revendications 6 à 10, dans lequel,
lors de l'étape de détection (830), la disponibilité opérationnelle n'est reconnue que lorsque l'évolution de tension détectée présente une augmentation de tension caractéristique.

12. Procédé (800) selon la revendication 12, dans lequel,
lors de l'étape d'identification (830), l'évolution de la tension est comparée à une valeur limite (U_{Grenz}) pour une tension.

13. Procédé (800) selon l'une quelconque des revendications 6 à 12, dans lequel,
la disponibilité opérationnelle n'est identifiée comme n'étant pas fournie lorsque l'évolution de tension détectée ne présente aucune augmentation de tension caractéristique.

14. Procédé (800) selon l'une quelconque des revendications 6 à 13, dans lequel,
une disponibilité opérationnelle du dispositif de commande (360, 740) du dispositif de sécurité est une polarité correcte du dispositif de commande (360, 740).

15. Procédé (800) selon l'une quelconque des revendications 6 à 14, dans lequel,
la tension peut être appliquée au dispositif de commande (360, 740) au moyen d'au moins un deuxième commutateur (320, 730), dans lequel,
lors de l'étape d'application (810), une tension est appliquée au moyen d'un deuxième commutateur (320, 730), notamment dans lequel l'au moins un deuxième commutateur (320, 730) est fermée.

16. Procédé (800) selon la revendication 15, dans lequel,
le dispositif de commande (360, 740) peut être déclenché au moyen de l'au moins un deuxième commutateur (320, 730) et d'au moins un troisième commutateur (340, 750), dans lequel
lors de l'étape d'application (810), un déclenchement est inhibé au moyen de l'au moins un troisième commutateur (340, 750), l'au moins un troisième commutateur n'étant notamment pas fermé.
